# EUROPEAN PATENT APPLICATION

(11) **EP 3 026 704 A1**
(43) Date of publication of application: **01.06.2016**
(21) Application number: 14829619.7
(22) Date of filing: 14.07.2014
(51) Int. Cl.: H01L 25/075, H01L 33/00

(54) **LIGHT-EMITTING DIODE DISPLAY SCREEN**

(30) Priority: 26.07.2013 CN 201310320930
(71) Applicant: Leyard Optoelectronic Co., Ltd, Beijing 100091 (CN)
(72) Inventor: LU, Changjun, Beijing 100091 (CN); YU, Jie, Beijing 100091 (CN); LIU, Zhiyong, Beijing 100091 (CN); PAN, Tong, Beijing 100091 (CN)
(74) Representative: Delorme, Nicolas
(86) International application number: PCT/CN2014/082169
(87) International publication number: WO 2015/010554

(57) **Abstract**

A Light Emitting Diode (LED) display screen includes: an LED display screen substrate (200), wherein the LED display screen substrate (200) is arranged with a driving circuit, an output end of the driving circuit includes: a first positive electrode (202) and a first negative electrode (204); an LED chip (210), located on the first surface,; a first jointing part (222) and a second jointing part (204), wherein the first positive electrode (202) is jointed to and electrically connected to the second positive electrode (212), and the first negative electrode (204) is jointed to and electrically connected to the second negative electrode (214) by the second jointing part (224). The LED display screen solves the technical problem in the related art that the minimum dot pitch of an LED display screen is excessively large due to a limited size of a support in a conventional encapsulated lamp bead.

## Description

### Technical field of the invention

The present invention relates to the field of display screens, particularly to a Light Emitting Diode (LED) display screen.

### Background of the invention

Generally, an LED display screen is combined by splicing a plural number of lamp beads in the related art, wherein a lamp bead product is mainly encapsulated by a Surface Mounted Device (SMD), and a chip. However, an SMD-encapsulated product and a chip-encapsulated product are size-limited, wherein the existing minimum size of an SMD-encapsulated lamp bead can only achieve 1.5mm*1.5mm while the existing minimum size of a chip-encapsulated lamp bead can only achieve 0.8mm*0.8mm, thus the size of an LED display screen is limited, the minimum dot pitch of an existing LED display screen is limited to 1.6mm, and application of LED display screens in the field of small size and high resolution LED display screens, e.g. in a home environment, is limited.

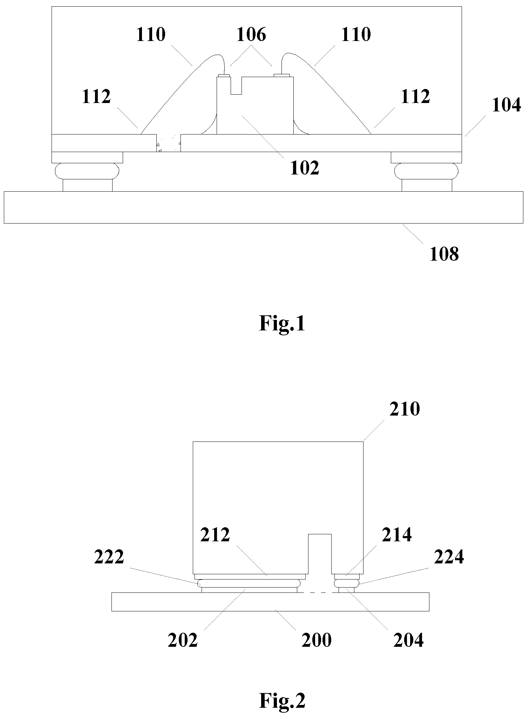

In a current stage, the sizes of conventional encapsulated lamp beads, i.e. SMD-encapsulated and chip-encapsulated lamp beads are mainly limited by an encapsulation structure. As shown in Fig. 1, a chip 102 is generally arranged on a support 104 in a conventional encapsulation process while the support 104 has a support function on one hand, and on the other hand, serves as an electric connection medium to connect a chip electrode 106 and a substrate 108, between Printed Circuit Boards (PCB) for example, wherein a recessed structure is generally arranged at an upper end of the support 104 so as to accommodate the chip 102 so that the chip 102 is fully fixed, thus the support 104 is usually designed with a large size and reduction of the size of an encapsulated lamp bead is limited.

Besides, an LED chip and a bonding pad are generally connected by a metal wire according to a wire bonding technique of a conventional encapsulated lamp bead, thus the quality of the lamp bead is directly affected by the welding quality of the metal wire. While a dot pitch of an LED display screen is reduced constantly, the conventional wire bonding technique also limits the development of LED display screens. As shown in Fig. 1, a welded part, i.e. the junction of a metal wire 110 and a chip 102 and the junction of the metal wire 110 and a bonding pad 112 on a support 104 are easily affected by an external force or a temperature to cause a fracture in the wire bonding technique of the conventional encapsulated lamp bead, thereby resulting in deficient brightness of the lamp bead to further affect the display performance of an LED display screen.

At present, there is no effective solution yet for the foregoing problem.

### Summary of the invention

An embodiment of the present invention provides an LED display screen, so as to at least solve the technical problem in the related art that the minimum dot pitch of an LED display screen is excessively large due to a limited size of a support in a conventional encapsulated lamp bead.

An LED display screen is provided according to an aspect of the embodiments of the present invention, including: an LED display screen substrate, wherein the LED display screen substrate is arranged with a driving circuit, an output end of the driving circuit includes: a first positive electrode and a first negative electrode and the first positive electrode and the first negative electrode are located on a first surface of the LED display screen substrate; an LED chip located on the first surface, wherein an input end of the LED chip includes: a second positive electrode and a second negative electrode, the second positive electrode and the second negative electrode are located on a second surface of the LED chip, and the second surface is opposite to the first surface; a first jointing part and a second jointing part, wherein the first positive electrode is jointed to and electrically connected to the second positive electrode by the first jointing part, and the first negative electrode is jointed to and electrically connected to the second negative electrode by the second jointing part.

Optionally, a plurality of said LED chips is arranged on the first surface of the LED display screen substrate, wherein the distance between two adjacent LED chips in the plurality of LED chips is set according to a preset dot pitch of the display screen.

Optionally, on the first surface, the plurality of LED chips is divided into a plurality of LED chip groups having the same arrangement structure, wherein each group in the plurality of LED chip groups includes: a first chip, a second chip and a third chip, wherein the first chip is configured to emit red lights, the second chip is configured to emit green lights and the third chip is configured to emit blue lights.

Optionally, the LED display screen further includes: an insulating rubber, located between the first jointing part and the second jointing part and implementing an insulating state between the first positive electrode and the first negative electrode and between the second positive electrode and the second negative electrode.

Optionally, the first jointing part and the second jointing part include: a metal weldment, connected between the first positive electrode and the second positive electrode, and/or between the first negative electrode and the second negative electrode.

Optionally, the first jointing part and the second jointing part include: a eutectic compound, connected between the first positive electrode and the second positive electrode, and/or between the first negative electrode and the second negative electrode.

Optionally, the first jointing part and/or the second jointing part include/includes: a conductive silver paste, cured and connected between the first positive electrode and the second positive electrode, and/or between the first negative electrode and the second negative electrode.

Optionally, the first jointing part and/or the second jointing part include/includes: an Anisotropic Conductive Paste (ACP), adhered between the first positive electrode and the second positive electrode, and/or between the first negative electrode and the second negative electrode.

Optionally, the ACP is adhered between the first positive electrode and the second positive electrode, and between the first negative electrode and the second negative electrode simultaneously and integrates the first jointing part and the second jointing part.

Optionally, the LED display screen further includes: a light transmitting plate, located outside the LED chip, and jointed or adjacent with a third surface of the LED chip, wherein the third surface is opposite to the second surface.

In the embodiments of the present invention, since an installation method of oppositely jointing an electrode of an LED chip and an electrode on an LED display screen substrate is applied, a support as used in a conventional encapsulation process is avoided so that the minimum dot pitch of an LED display screen in the embodiments of the present invention is no longer limited by a size of the support, thus the technical problem in the related art that the minimum dot pitch of an LED display screen is excessively large due to a limited size of a support in a conventional encapsulated lamp bead is solved on the basis of ensuring relatively small sizes of a first jointing part and a second jointing part between a chip electrode and a substrate electrode, and the technical effect of reducing the minimum dot pitch of the LED display screen is implemented. Further, use of a metal wire for electrically connecting an LED chip and the support in the conventional encapsulation process is avoided in the embodiments of the present invention, thus eliminating the influence of the welding quality on the performance of the LED display screen to further achieve the technical effect of improving the reliability of the LED display screen.

### Brief description of the drawings

The accompanying drawings illustrated herein are used for providing further understanding to the present invention and constitute a part of the application. The exemplary embodiments of the present invention and illustration thereof are used for explaining the present invention, instead of constituting improper limitation to the present invention. In the accompanying drawings:
Fig. 1 is a schematic diagram of an LED lamp bead according to a related encapsulation technology;
Fig. 2 is a schematic diagram of an optional LED display screen according to an embodiment of the present invention;
Fig. 3 is a schematic diagram of another optional LED display screen according to an embodiment of the present invention;
Fig. 4 is a schematic diagram of still another optional LED display screen according to an embodiment of the present invention;
Fig. 5 is a schematic diagram of still another optional LED display screen according to an embodiment of the present invention;
Fig. 6 (a) is a schematic diagram of still another optional LED display screen according to an embodiment of the present invention;
Fig. 6 (b) is a schematic diagram of still another optional LED display screen according to an embodiment of the present invention;
Fig. 7 is a schematic diagram of a manufacturing method of an optional LED display screen according to an embodiment of the present invention;
Fig. 8 is a schematic diagram of a manufacturing method of another optional LED display screen according to an embodiment of the present invention;
Fig. 9 is a schematic diagram of still another optional LED display screen according to an embodiment of the present invention;
Fig. 10 is a schematic diagram of an arrangement method of LED chips in an optional LED display screen according to an embodiment of the present invention;
Fig. 11 is a schematic diagram of an arrangement method of LED chips in another optional LED display screen according to an embodiment of the present invention;
Fig. 12 is a schematic diagram of a location relationship of LED chips in an optional LED display screen according to an embodiment of the present invention; and
Fig. 13 is a schematic diagram of still another optional LED display screen according to an embodiment of the present invention.

### Detailed description of the embodiments

The present invention will be expounded hereinafter with reference to the accompanying drawings and in conjunction with the embodiments. It needs to be noted that the embodiments in the application and the characteristics in the embodiments may be combined with each other if there is no conflict.

An embodiment of the present invention provides a preferred LED display screen. As shown in Fig. 2, the LED display screen includes:
1) an LED display screen substrate 200, wherein the LED display screen substrate 200 is arranged with a driving circuit, an output end of the driving circuit includes: a first positive electrode 202 and a first negative electrode 204 and the first positive electrode 202 and the first negative electrode 204 are located on a first surface of the LED display screen substrate 200;
2) an LED chip 210 located on the first surface, wherein an input end of the LED chip 210 includes: a second positive electrode 212 and a second negative electrode 214, the second positive electrode 212 and the second negative electrode 214 are located on a second surface of the LED chip 210, and the second surface is opposite to the first surface;
3) a first jointing part 222 and a second jointing part 224, wherein the first positive electrode 202 is jointed to and electrically connected to the second positive electrode 212 by the first jointing part 222, and the first negative electrode 204 is jointed to and electrically connected to the second negative electrode 214 by the second jointing part 224.

The LED display screen substrate 200 in the LED display screen provided according to the embodiment of the present invention may be arranged with the driving circuit, wherein the driving circuit may be configured to generate a control voltage and/or a control current while the first positive electrode 202 and the first negative electrode 204 serving as output ends of the driving circuit may be configured to output the control voltage and/or the control current, thus the control voltage and/or the control current may be configured to control a light emitting state of the LED chip 210.

In the embodiment of the present invention, a specific threshold range of the control voltage and/or the control current may be set according to a specification and/or a model of the LED chip 210 controlled by the control voltage and/or the control current, thus the driving circuit configured to generate the control voltage and/or the control current may be also provided with various feasible corresponding forms and structures, which will not be described repeatedly here in the embodiment of the present invention.

As shown in Fig. 2, in the embodiment of the present invention, the first positive electrode 202 and the first negative electrodes 204 serving as the output ends of the driving circuit may be located at the same side of the LED display screen substrate 200, wherein a surface of the LED display screen substrate 200 at the side is denoted by the first surface so as to facilitate description. It needs to be noted that a positive electrode and a negative electrode called in the embodiments of the present invention are only provided to represent a corresponding connection relationship between an electric connection end and a corresponding electric connection end thereof, but should not be understood that there is any other unnecessary limitation. For example, in same embodiments of the present invention, there may be a plurality of first positive electrodes 202 on the first surface of the LED display screen substrate 200, and a corresponding first negative electrode 204 may be a common end. The common end may manifest as a metal sheet having a specific shape or a bonding pad connected by a conductor, and so on.

Optionally, there may be a plurality of options and combinations of the shapes, structures or materials of the first positive electrode 202 and the first negative electrode 204 in the embodiment of the present invention. For example, in terms of shapes, the first positive electrode 202 and the first negative electrode 204 may be rectangular, or may be also circular or semicircular, or in a shape formed by combining a circle and a rectangle; in terms of materials, the first positive electrode 202 and the first negative electrode 204 may be silver electrodes, or may be also metal materials including copper, gold and so on, or other conductor materials; in terms of structures, the first positive electrode 202 and the first negative electrode 204 are arranged with smooth surfaces fitted with the LED chip 210, or may be also partly or wholly provided with a certain curvature, or may be further provided with a preset texture or a structure including a convex or a groove and so on, wherein the surfaces of the first positive electrode 202 and the first negative electrode 204 may be aligned with the LED display screen substrate 200, or may be also provided with relatively evident convexes relative to the surface of the LED display screen substrate 200, or may be also arranged according to the structure of an electrode of the LED chip 210. For example, the first positive electrode 202 and the first negative electrode 204 may be provided with different heights or thicknesses. Of course, the above are only some examples, and the embodiments of the present invention do not make any improper limitation to this.

On the other hand, the LED display screen substrate 200 in the embodiment of the present invention may be generally a PCB. However, in some embodiments of the present invention, the LED display screen substrate 200 may be also a ceramic circuit board, such as a porous ceramic circuit board, a Low Temperature Co-fired Ceramic (LTCC) circuit board and so on, or is designed by applying other feasible materials that may be used as a circuit board or feasible processes, which is not limited by the embodiments of the present invention. It is worth noting that the LED display screen substrate 200 in the embodiment of the present invention is not identically understood as an LED substrate in a general sense, but should be understood as a feasible substrate, including an LED substrate that may be used for assembling a LED display screen.

As shown in Fig. 2, the LED display screen provided according to the embodiment of the present invention may further include the LED chip 210 located on the first surface, wherein the second positive electrode 212 and the second negative electrode 214 serving as input ends of the LED chip 210 may be located at the same side of the LED chip 210, wherein a surface of the LED chip 210 at the side may be denoted by the second surface so as to facilitate description,
wherein the second positive electrode 212 and the second negative electrode 214 located on the second surface may represent a positive electrode and a negative electrode of the LED chip 210, respectively, wherein the LED chip 210 may be in different light emitting states according to different amplitudes of a control voltage and/or a control current inputted by the second positive electrode 212 and the second negative electrode 214, wherein it is worth noting that the light emitting states of the LED chip 210 may be not only configured to represent on and off states of the LED chip 210, but also configured to represent light emitting states of different brightness of the LED chip 210, and may be even configured to represent light emitting states of different colors of the LED chip 210, which is not limited by the embodiments of the present invention.

Generally, the LED chip 210 may apply a related LED chip 210 product directly in the embodiment of the present invention. Optionally, the LED chip 210 may be selected from various specifications and/or models. For example, the LED chip may be a high power chip, or may be also a low power chip, may be a single tube chip, or may be also a digital chip, a lattice chip, or a chip for decoration and illumination, and so on, which is not limited by the embodiments of the present invention. Optionally, the sizes of the LED chip 210, and performance parameters including a positive onset voltage, a rated current, a light emitting power and so on are also not specifically limited by the embodiments of the present invention. Optionally, each parameter of the LED chip 210 may be configured according to a design requirement and an application environment of the LED display screen. Of course, in some embodiments of the present invention, the LED chip 210 may be also a specific LED chip 210 product designed by a technician according to a related product requirement, which is not limited by the embodiments of the present invention.

As shown in Fig. 2, different from the related art, the side, i.e. the second surface on the LED chip 210, where the second positive electrode 212 and the second negative electrode 214 are distributed may be opposite to the first surface of the LED display screen substrate 200 in the embodiment of the present invention, but is not set back to back with the first surface in a related encapsulation process as shown in Fig. 1, thus a spatial structure formed by the chip electrodes and the substrate electrodes is more compact compared with the related encapsulation process, so that a connection structure between the LED chip 210 and the LED display screen substrate 200 in the LED display screen provided by the embodiment of the present invention may be provided with a design of a smaller size.

Optionally, as shown in Fig. 2, the LED display screen in the embodiment of the present invention may further include the first jointing part 222 and the second jointing part 224, wherein the first positive electrode 202 may be jointed to and electrically connected to the second positive electrode 212 by the first jointing part 222, and the first negative electrode 204 may be jointed to and electrically connected to the second negative electrode 214 by the second jointing part 224.

In the scenario above, an electric connection relationship is formed between the substrate electrodes and the chip electrodes through the first jointing part 222 and the second jointing part 224, thereby forming a conduction circuit between the driving circuit and the LED chip 210 in the LED display screen substrate 200 so as to control the LED chip 210 through the control voltage/the control current outputted by the driving circuit to further implement a display function of the LED display screen.

Besides, as shown in Fig. 2, since an installation method of jointing the electrodes of the chip 210 and the electrodes on the LED display screen substrate 200 oppositely is applied in the embodiment of the present invention, a support as used in a conventional encapsulation process is avoided so that the minimum dot pitch of the LED display screen in the embodiment of the present invention is no longer limited by a size of the support, thus the technical problem in the related art that the minimum dot pitch of an LED display screen is excessively large due to a limited size of a support in a conventional encapsulated lamp bead is solved on the basis of ensuring relatively small sizes of a first jointing part 222 and a second jointing part 224 between a chip electrode and a substrate electrode, and the technical effect of reducing the minimum dot pitch of the LED display screen is implemented. Further, use of a metal wire for electrically connecting an LED chip 210 and the support in the conventional encapsulation process is avoided in the embodiment of the present invention, thus eliminating the influence of the welding quality on the performance of the LED display screen to further achieve the technical effect of improving the reliability of the LED display screen.

Various specific embodiments of the first jointing part 222 and the second jointing part 224 will be expounded below.

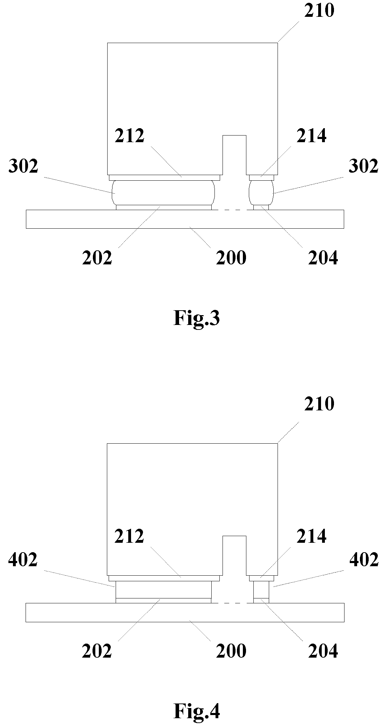

Referring to Fig. 3 to Fig. 5, and Fig. 6 (a) and Fig. 6 (b), as optional embodiments of the embodiments of the present invention, the first jointing part 222 and the second jointing part 224 may include at least one of the followings:
1) A metal weldment 302, connected between the first positive electrode 202 and the second positive electrode 212, and/or between the first negative electrode 204 and the second negative electrode 214.
2) A eutectic compound 402, connected between the first positive electrode 202 and the second positive electrode 212, and/or between the first negative electrode 204 and the second negative electrode 214.
3) A conductive silver paste 502, cured and connected between the first positive electrode 202 and the second positive electrode 212, and/or between the first negative electrode 204 and the second negative electrode 214.
4) An ACP 602, adhered between the first positive electrode 202 and the second positive electrode 212, and/or between the first negative electrode 204 and the second negative electrode 214,
wherein a corresponding optional connection method, i.e. a chip fixing method, between the chip electrodes and the substrate electrodes through the first jointing part 222 and/or the second jointing part 224 in the first implementation method may be a jointing method of planting a gold ball, wherein as shown in Fig. 3, the metal weldment 302 may be a gold ball planted on the first positive electrode 202 and the first negative electrode 204 of the LED display screen substrate 200 respectively, and the other side of the gold ball is jointed with the second positive electrode 212 and the second negative electrode 214 of the LED chip 210 respectively.

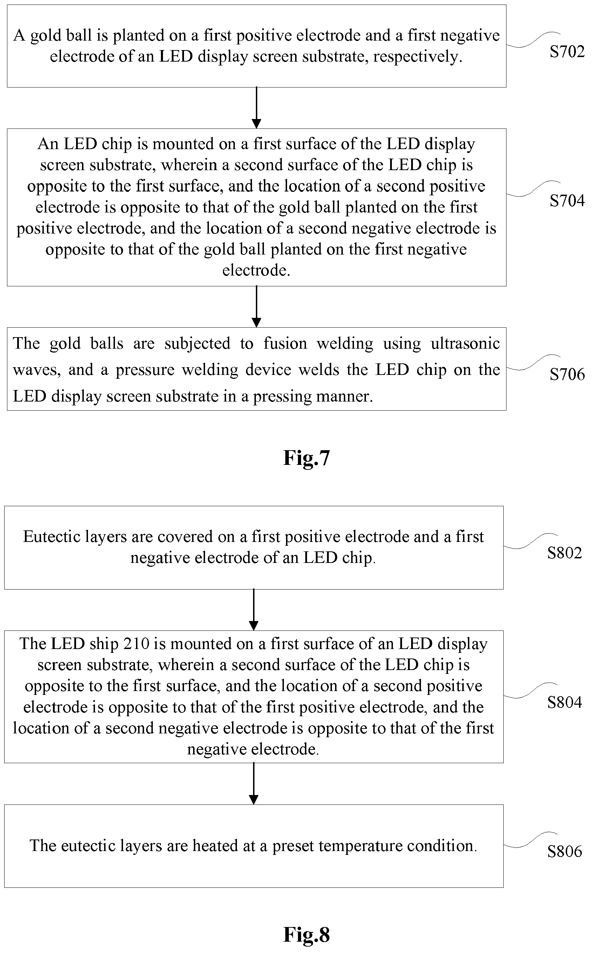

Optionally, a manufacturing process may be as shown in Fig. 7, including the following steps:
Step 702: A gold ball is planted on the first positive electrode 202 and the first negative electrode 204 of the LED display screen substrate 200, respectively.

Step 704: The LED chip 210 is mounted on the first surface of the LED display screen substrate 200, wherein the second surface of the LED chip 210 is opposite to the first surface, and the location of the second positive electrode 212 is opposite to that of the gold ball planted on the first positive electrode 202, and the location of the second negative electrode 214 is opposite to that of the gold ball planted on the first negative electrode 204.

Step 706: The gold balls are subjected to fusion welding using ultrasonic waves, and a pressure welding device welds the LED chip 210 on the LED display screen substrate 200 in a pressing manner.

Of course, the above is only an example and is not limited by the embodiments of the present invention. For example, the following step may be also included before Step 704 in some embodiments of the present invention: the horizontal locations of the gold balls on the first positive electrode 202 and the first negative electrode 204 are calibrated. Besides, the following step may be also included before Step 706: the LED chip 210, corresponding bonding pads of the first positive electrode 202 and the second positive electrode 212 on the LED display screen substrate 200, and/or the gold balls on the first positive electrode 202 and the second positive electrode 212 are preheated, and so on.

Besides, in some other embodiments of the present invention, the first jointing part 222 and the second jointing part 224 may be also metal weldments 302 formed by gold sheets or gold plates, but not the gold balls. In addition, the metal weldments 302 may be also metals or alloy materials besides gold, such as soldering tin, and the embodiments of the present invention do not make any limitation thereto.

A corresponding chip fixing method of the second implementation method may be a eutectic bonding method in an embodiment of the present invention, wherein the first positive electrode 202 and the first negative electrode 204 of the LED display screen substrate 200 may be respectively jointed with the second positive electrode 212 and the second negative electrode 214 of the LED chip 210 through the eutectic compound 402, as shown in Fig. 4.

Optionally, a manufacturing process may be as shown in Fig. 8, including the following steps:
Step 802: Eutectic layers are covered on the first positive electrode 202 and the first negative electrode 204 of the LED chip 210.

Step 804: The LED ship 210 is mounted on the first surface of the LED display screen substrate 200, wherein the second surface of the LED chip 210 is opposite to the first surface, and the location of the second positive electrode 212 is opposite to that of the first positive electrode 202, and the location of the second negative electrode 214 is opposite to that of the first negative electrode 204.

Step 806: The eutectic layers are heated at a preset temperature condition.

Of course, the above is only an example, and is not limited by the embodiments of the present invention. For example, some embodiments of the present invention may also apply a jointing method of performing a eutectic process assisted by a welding flux instead of applying a direct eutectic process, wherein an auxiliary welding flux may be arranged on the first positive electrode 202 and the first negative electrode 204 of the LED display screen substrate 200 in advance.

Besides, the eutectic layers in Step 802 may be selected from various materials, and may be Au80Sn20 generally. However, the eutectic layers may be also formed by compounds including CuSn or PbSn and so on in some other embodiments of the present invention, which is not limited by the embodiment of the present invention.

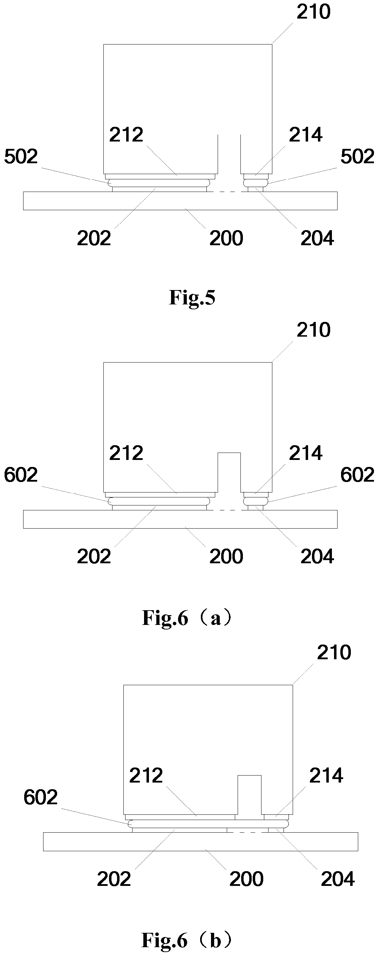

Similar to the second implementation method, the chip electrodes may be aligned with the substrate electrodes first in third implementation method in an embodiment of the present invention, and the conductive silver paste 502 coated between the chip electrodes and the substrate electrodes is cured and adhered between the first positive electrode 202 and the second positive electrode 212 and between the first negative electrode 204 and the second negative electrode 214 by means of heating and so on, as shown in Fig. 5, which will not be described repeatedly in the embodiment of the present invention.

A corresponding chip fixing method of the third implementation method may be an ACP jointing method in an embodiment of the present invention, wherein the first positive electrode 202 and the first negative electrode 204 of the LED display screen substrate 200 may be jointed with the second positive electrode 212 and the second negative electrode 214 of the LED chip 210 through the ACP 602, as shown in Fig. 6 (a).

Optionally, as shown in Fig. 6 (b), as a preferred implementation method, the ACP 602 may be also adhered between the first positive electrode 202 and the second positive electrode 212, and between the first negative electrode 204 and the second negative electrode 214 at the same time, and integrates the first jointing part 222 and the second jointing part 224.

In Fig. 6 (b), different from the connection structure that the first jointing part 222 and the second jointing part 224 are separated in the first implementation method, the second implementation method and the third implementation method, the ACP 602 may be formed to be integrally adhered between the substrate electrodes and the chip electrodes, wherein as a polymeric bonding agent, the anisotropy of the ACP may enable the ACP 602 to have better electrical conductivity in a direction vertical to the first surface and the second surface while the electrical conductivity in a direction parallel to the first surface and the second surface is worse, wherein the electrical conductivity in the directions above may be implemented by a change of the electrical conductivity with the directions due to insufficient contact between crystalline grains caused by a conductive filler material having a relatively low capacity. Since the ACP 602 may be integrally coated between the substrate electrodes and the chip electrodes in the scenario above, alignment between the first positive electrode 202 and the second positive electrode 212 and between the first negative electrode 204 and the second negative electrode 214 is avoided, and a possible short circuit caused by mutual contact of the first jointing part 222 and the second jointing part 224 in the first implementation method to the third implementation method is avoided, thereby achieving the technical effect of improving the reliability of the LED display screen while reducing a requirement on the precision of a chip fixing device and the manufacturing cost of the LED display screen.

Besides, it may be also seen from the foregoing description that besides forming a connection loop between the LED display screen substrate 200 and the LED chip 210, the first jointing part 222 and the second jointing part 224 in the first implementation method to the fourth implementation method may also fix the LED chip 210 on the LED display screen substrate 200, thereby also implementing the technical effect of improving the reliability of the LED display screen.

Of course, provided as examples, the first implementation method to the fourth implementation method are used for explaining the technical solutions of the present invention in more details, but should not be understood as forming any limitation to the present invention. The technical solutions of the present invention may be also implemented by other methods, which will not be described repeatedly here.

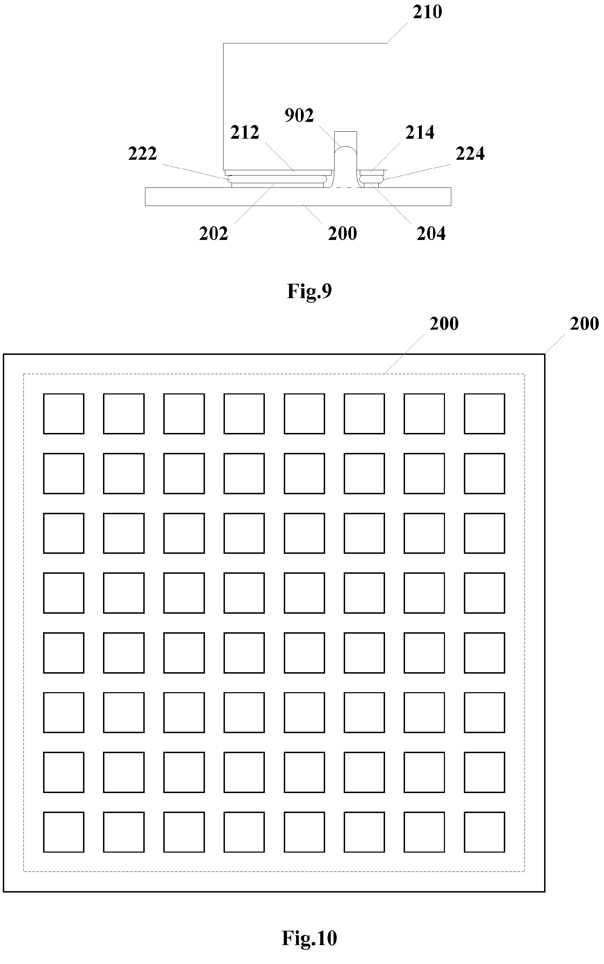

Optionally, as shown in Fig. 9, in the embodiment of the present invention, the LED display screen may further include:
1) An insulating rubber 902, located between the first jointing part 222 and the second jointing part 224 and implementing an insulating state between the first positive electrode 202 and the first negative electrode 204 and between the second positive electrode 212 and the second negative electrode 214.

As described above, in the first implementation method to the third implementation method, the mutual contact between the first jointing part 222 and the second jointing part 224 may cause a short circuit of the driving circuit which is located on the LED display screen substrate 200 to drive the LED chip 210. As shown in Fig. 9, the insulating rubber 902 may be also filled between the first jointing part 222 and the second jointing part 224 according to the LED display screen in the embodiment of the present invention, so as to at least solve this problem, thereby solving the problem of the short circuit and implementing the technical effect of improving the reliability of the LED display screen.

Optionally, the insulating rubber 902 may have various options, such as epoxy resin and so on. It is worth noting that the insulating rubber 902 may be in a liquid state, and may be also in a solid state or a mixture of a liquid and a solid, which is not limited by the embodiments of the present invention.

By means of the embodiments above, the embodiments of the present invention have elaborated a structure taking the chip as the smallest unit in the LED display screen. Optionally, the embodiments of the present invention will expound an arrangement structure of LED chips 210 on the LED display screen by means of the following embodiments,
wherein as shown in Fig. 10, a plurality of said LED chips 210 may be optionally arranged on the first surface of the LED display screen substrate 200, wherein the distance between two adjacent LED chips in the plurality of LED chips 210 may be set according to a preset dot pitch of the display screen.

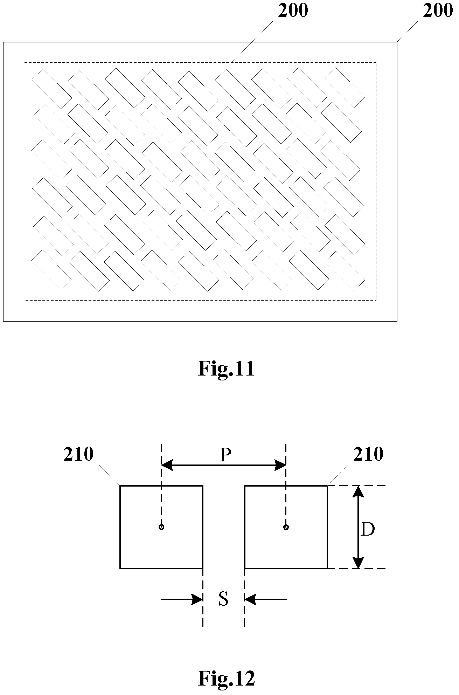

As shown in Fig. 10, the plurality of LED chips 210 may be generally aligned regularly by means of a rectangular lattice in an embodiment of the present invention. However, it does not mean that an arrangement method of the LED chips 210 is limited by the embodiment of the present invention. For example, the plurality of LED chips 210 may be also arranged in other ways. For example, a method of arranging the chips in a slanting and intersecting manner may be applied, as shown in Fig. 11. Besides, the LED chips 210 may be also arranged along a preset pattern, which is not limited by the embodiment of the present invention.

Optionally, the distance between two adjacent LED chips in the plurality of LED chips 210 may be set according to a size of the chips and a design requirement, such as the minimum dot pitch, of the LED display screen in the embodiment of the present invention. For example, as shown by Fig. 12, in the case that the shapes of light emitting surfaces of the LED chips 210 are squares, the distance S between two adjacent LED chips 210 may be set according to the following formula:
S=P-D, where S is provided to represent the distance between the chips, P is provided to represent a preset minimum dot pitch and D is provided to represent a side length of the squares serving as the outlines of the light emitting surfaces of the chips.

On the other hand, an arrangement method of the LED chips 210 for an LED display screen having a design requirement of color display may be further set according to the design requirement, an imaging resolution and so on in some embodiments of the present invention. For example, as an optional embodiment of the present invention, on the first surface of the LED display screen substrate 200, the plurality of LED chips 210 are divided into a plurality of LED chip 210 groups having the same arrangement structure, wherein each of the plurality of LED chip 210 groups includes: a first chip, a second chip and a third chip, wherein the first chip is configured to emit red lights, the second chip is configured to emit green lights and the third chip is configured to emit blue lights.

In the scenario above, lights of three colors, i.e. red lights, green lights and blue lights of different proportions may be synthesized, according to the principles of the three primary colors, into lights of other colors recognizable by human eyes, thereby the driving circuit may provide an adjustable control voltage and/or control current to the first chip, the second chip and the third chip so as to control the color and brightness of the LED display screen.

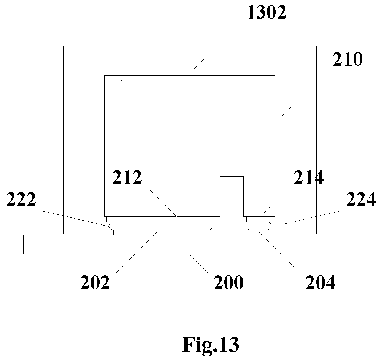

Optionally, as shown in Fig. 13, the LED display screen may further include the followings in an embodiment of the present invention.
1) A light transmitting plate 1302, located outside the LED chip 210, and jointed or adjacent with a third surface of the LED chip 210, wherein the third surface is opposite to the second surface,
wherein the light transmitting plate 1302 may be configured to encapsulate and protect a display side of the LED display screen, wherein the light transmittance of the light transmitting plate 1302 may be set according to a design requirement. Besides, the embodiments of the present invention make no limitation to a specific material and a shape of the light transmitting plate 1302.

The present invention provides the foregoing preferred embodiments to further explain the present invention, but it is worth noting that the foregoing preferred embodiments only serve to better describe the present invention, but do not constitute improper limitation to the present invention.

It may be seen from the foregoing description that the present invention has implemented the following technical effect.
1) An installation method of directly jointing an electrode of an LED chip 210 and an electrode on an LED display screen substrate 200 is applied, thereby avoiding the dependency on a support in a conventional encapsulation process so that the minimum dot pitch of an LED display screen in the embodiments of the present invention is no longer limited by a size of the support, and achieving the technical effect of reducing the minimum dot pitch of the LED display screen.
2) Use of a metal wire for electrically connecting an LED chip 210 and the support in the conventional encapsulation process is avoided, thus eliminating the influence of the welding quality on the performance of the LED display screen to further achieve the technical effect of improving the reliability of the LED display screen.

The above are only preferred embodiments of the present invention, but are not used for limiting the present invention. For those skilled in the art, the present invention may have various modifications and changes. Any modifications, equivalent replacements, improvements and the like made within the spirit and principles of the present invention shall be included in the scope of protection of the present invention.

### Industrial applicability

The embodiments of the present invention apply an installation method of directly jointing an electrode of an LED chip and an electrode on an LED display screen substrate, thereby avoiding the dependency on a support in a conventional encapsulation process so that the minimum dot pitch of an LED display screen in the embodiments of the present invention is no longer limited by a size of the support, and achieving the technical effect of reducing the minimum dot pitch of the LED display screen. Further, use of a metal wire for electrically connecting an LED chip and the support in the conventional encapsulation process is avoided in the embodiments of the present invention, thus eliminating the influence of the welding quality on the performance of the LED display screen to further achieve the technical effect of improving the reliability of the LED display screen.

## Claims

1. A Light Emitting Diode (LED) display screen, comprising:
an LED display screen substrate, wherein the LED display screen substrate is arranged with a driving circuit, an output end of the driving circuit includes: a first positive electrode and a first negative electrode and the first positive electrode and the first negative electrode are located on a first surface of the LED display screen substrate;
an LED chip located on the first surface, wherein an input end of the LED chip includes: a second positive electrode and a second negative electrode, the second positive electrode and the second negative electrode are located on a second surface of the LED chip, and the second surface is opposite to the first surface;
a first jointing part and a second jointing part, wherein the first positive electrode is jointed to and electrically connected to the second positive electrode by the first jointing part, and the first negative electrode is jointed to and electrically connected to the second negative electrode by the second jointing part.

2. The LED display screen according to claim 1, wherein
a plurality of said LED chips is arranged on the first surface of the LED display screen substrate, wherein the distance between two adjacent LED chips in the plurality of LED chips is set according to a preset dot pitch of the display screen.

3. The LED display screen according to claim 2, wherein
on the first surface, the plurality of LED chips is divided into a plurality of LED chip groups having the same arrangement structure, wherein each group in the plurality of LED chip groups includes: a first chip, a second chip and a third chip, wherein the first chip is configured to emit red lights, the second chip is configured to emit green lights and the third chip is configured to emit blue lights.

4. The LED display screen according to claim 1, wherein the LED display screen further includes:
an insulating rubber, located between the first jointing part and the second jointing part and implementing an insulating state between the first positive electrode and the first negative electrode and between the second positive electrode and the second negative electrode.

5. The LED display screen according to any one of claims 1 to 4, wherein the first jointing part and the second jointing part include:
a metal weldment, connected between the first positive electrode and the second positive electrode, and/or between the first negative electrode and the second negative electrode.

6. The LED display screen according to any one of claims 1 to 4, wherein the first jointing part and the second jointing part include:
a eutectic compound, connected between the first positive electrode and the second positive electrode, and/or between the first negative electrode and the second negative electrode.

7. The LED display screen according to any one of claims 1 to 4, wherein the first jointing part and/or the second jointing part include/includes:
a conductive silver paste, cured and connected between the first positive electrode and the second positive electrode, and/or between the first negative electrode and the second negative electrode.

8. The LED display screen according to any one of claims 1 to 3, wherein the first jointing part and/or the second jointing part include/includes:
an Anisotropic Conductive Paste (ACP), adhered between the first positive electrode and the second positive electrode, and/or between the first negative electrode and the second negative electrode.

9. The LED display screen according to claim 8, wherein
the ACP is adhered between the first positive electrode and the second positive electrode, and between the first negative electrode and the second negative electrode simultaneously and integrates the first jointing part and the second jointing part.

10. The LED display screen according to any one of claims 1 to 4, wherein the LED display screen further includes:
a light transmitting plate, located outside the LED chip, and jointed or adjacent with a third surface of the LED chip, wherein the third surface is opposite to the second surface.
